# EUROPEAN PATENT APPLICATION

(11) **EP 3 261 097 A1**
(43) Date of publication of application: **27.12.2017**
(21) Application number: 16752451.1
(22) Date of filing: 16.02.2016
(51) Int. Cl.: H01B 7/06, H01B 7/08, H01B 13/00, H05K 1/02, H05K 1/09, H05K 1/18, H05K 3/10

(54) **HIGHLY ELASTIC WIRING, AND METHOD AND DEVICE FOR PRODUCING SAME**

(30) Priority: 20.02.2015 JP 2015031278
(71) Applicant: National Institute of Advanced Industrial Science and Technology, Tokyo 100-8921 (JP)
(72) Inventor: YOSHIDA Manabu, Tsukuba-shi Ibaraki 305-8565 (JP); UEMURA Sei, Tsukuba-shi Ibaraki 305-8565 (JP); NOBESHIMA Taiki, Tsukuba-shi Ibaraki 305-8565 (JP)
(74) Representative: Cabinet Netter
(86) International application number: PCT/JP2016/054377
(87) International publication number: WO 2016/133065

(57) **Abstract**

Conductor wires 2a and 2b are sandwiched between two elastomer sheets 1a and 1b whose adhesive layers face each other, and both adhere. When the elastomer sheets 1a and 1b are their natural lengths without being subjected to any tension, the conducting wires 2a and 2b are wound around into spiral shapes and contract. When tension is applied to the elastomer sheets 1a and 1b, the number of spiral turns of the conductor wires 2a and 2b decreases according to its extension and the conductor wires 2a and 2b extend. The conductor wires 2a and 2b are electrically connected to and fixed to a circuit element at both ends of the elastomer sheets 1a and 1b. As a result, it is possible to mass-produce, at low costs, highly stretchable wirings in which a change in resistance values due to extension thereof is small.

## Description

### TECHNICAL FIELD

The present invention relates to a highly stretchable wiring that is superior in stretchability and bendability, and to a producing method and a producing device thereof.

### BACKGROUND ART

In recent years, the demand for such a highly stretchable wiring, for example, an antenna and wiring for an RFID apparatus in which flexibility is required; a wiring in a motion analyzing sensor in sports science; a garment-type heartbeat and electrocardiogram monitor; a wiring for a robot movable part, a wiring for a finger sensor for sending an instruction to a computer; a wiring for a bendable sensor attached to a finger, an elbow joint or a knee joint that is used for remotely controlling a robot; or the like increases in various fields.

Patent Document 1 has disclosed producing conductive rubber having stretchability by dispersing an ionic fluid, and carbon nanotubes in rubber.

Patent Document 2 has disclosed producing an elastic circuit substrate by sticking a copper wiring having a wave-shaped structure onto an elastomer.

Patent Document 3 has disclosed disposing, on a lower surface of an elastomer sheet made of ester-based urethane rubber, a wiring made of urethane rubber and silver powder.

Patent Document 4 has disclosed disposing a booster antenna made of conductive fibers in an unadhesive state so as to oppose an antenna with an IC chip.

### RELATED ART DOCUMENTS

### PATENT DOCUMENTS

Patent Document 1: International Publication No. 2009-102077
Patent Document 2: Japanese Patent Application Laid-open No. 2013-187380
Patent Document 3: Japanese Patent Application Laid-open No. 2011-34822
Patent Document 4: Japanese Patent Application Laid-open No. 2013-206080

### SUMMARY OF THE INVENTION

### PROBLEMS TO BE SOLVED BY THE INVENTION

Patent Document 1 has described developing conductivity by dispersing carbon nanotubes, metal nanowires or the like in order to form a stretchable conductor. These materials are expensive. In order to obtain sufficient conductivity, however, a content rate thereof needs to be made very high. Therefore, a final product naturally becomes very expensive, and this brings a barrier to popularization in the fields of sports science and medicine.

On the other hand, as shown in Patent Document 2, about techniques for developing stretchability by a structure of a metal pattern itself similarly to a wave-shaped wiring or the like, problems arises in that a process is complicated and in that the obtained stretchability is not so high.

As shown in Patent Document 3, when conductor wires each developing stretchability are individually produced by sealing silver powder in urethane rubber, problems arise in that: high costs are required; in that flexibility is impaired; and if electrical contact between silver powders is disconnected at any place, a function as the conductor wire is impaired.

As shown in Patent Document 4, when conductive fibers are utilized, the conductive fibers themselves are expensive. In addition, it is necessary to cut out a conductive fiber sheet in forming various kinds of antennas. Therefore, there are many wasteful conductive fiber sheets, high costs are further required, and a degree of freedom in antenna modes is limited.

Therefore, an object of the present invention is to provide a highly stretchable wiring that can be mass-produced at low costs by using a very simple producing process, and that has a small variation in resistance value due to extension while exerting superior extensibility and durability.

### MEANS FOR SOLVING THE PROBRELMS

In order to solve the above problems, a highly stretchable wiring according to the present invention includes at least: two elastomer sheets each having an adhesive layer, the both adhesive layers adhering to each other along a longitudinal direction on wide-directional both sides; and a high windable conductor wire wound in a spiral shape and contracted when the elastomer sheets have natural lengths without being subjected to any tension, and extending by reducing the number of spiral turns according to extension due to tension applied between both ends of the elastomer sheets, in which the conductor wire is interposed between the elastomer sheets, is extended from surfaces of the elastomer sheets on the both ends of the elastomer sheets, is electrically connected with a circuit element, and is fixed thereon.

A producing method for a highly stretchable wiring according to the present invention includes the steps of: extending two elastomer sheets, whose adhesive layers are opposed to each other, within a limit elongation rate or less by holding both ends thereof and applying tension thereto; sandwiching a highly windable conductor wire between the both elastomer sheets, and adhering to each other with the conductor wire being fixed to the both ends of the elastomer sheets; and releasing extension of the elastomer sheets to return to their natural lengths, winding around the conductor wire in a spiral shape, and contracting to the natural lengths.

### EFFECTS OF THE INVENTION

In accordance with the highly stretchable wiring of the present invention, conductor wires each wound into a spiral shape are extended/contracted in response to an extension/contraction of an elastomer sheet by changing the number of turns therein and a pitch therebetween, and so it becomes possible to reduce a change in resistance value due to its extension while exerting superior extensibility and durability.

Moreover, in accordance with the production method of the highly stretchable wiring of the present invention, simply by sandwiching a conductor wire having high turnability between two sheets of extended elastomer sheets and by sticking it therebetween, it becomes possible to mass-produce the above-mentioned highly stretchable wiring at low costs.

### BRIEF DESCRIPTIONS OF THE DRAWINGS

FIG. 1 is a drawing showing a basic structure of an embodiment;
FIG. 2 is a drawing that shows processes in which conductor wires are sandwiched and stuck between two elastomer sheets in a state of extending the sheets at an elongation rate of 400% (initial elongation rate) and then the sheets return to their natural lengths;
FIG. 3 is a drawing showing measurement results of a resistance value ohm as a whole, a resistance value per 1 cm (unit resistance value ohm/cm), a wiring width (width of conductor wire: mm) and a twisting pitch (length per 1 twist) when the initial elongation rate is changed from 0% (natural length) to 400% with respect to various samples;
FIG. 4 is a drawing showing a resistance-value variation characteristic in using five conductor wires by lightly twisted to extend them up to 200% (three times longer than the natural length);
FIG. 5 is a drawing showing a termination connecting structure for electrically connecting a circuit base material with a termination of a highly stretchable wiring;
FIG. 6 is a drawing that shows an extended state in which locations fixed to stuck portions and a non-fixed location therebetween are alternately mixed with the same width;
FIG. 7 is a drawing showing a matrix-shaped device using highly stretchable wirings of the preset invention; and
FIG. 8 is a drawing showing a highly stretchable wiring producing device of the present invention in which rolls are used.

### DETAILED DESCRIPTION OF PREFERED EMBODIMENTS

Hereinafter, an embodiment for implementing the present invention will be described with reference to the drawings.

### EMBODIMENTS

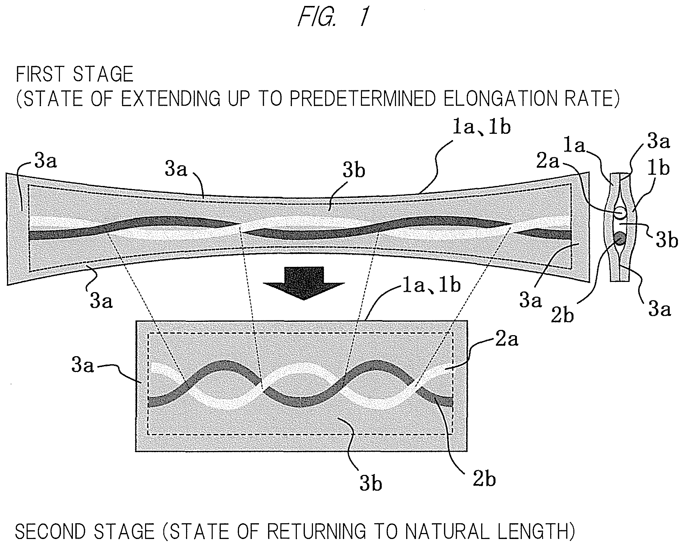

FIG. 1 is a drawing that explains a basic structure of an embodiment of the present invention.

Each of two elastomer sheets 1a and 1b is made of urethane elastomer or the like whose limit elongation rate having a possibility of breaking is about 600% (7 times as long as its natural length), and an adhesive layer or a bond layer (hereinafter, referred to simply as "adhesive layer") is formed on one surface of each of the sheets.

With the adhesive layers of the elastomer sheets 1a and 1b opposed to each other, upper surfaces in respective width directions of ends are held by a holding device, and are extended to an initial elongation rate of, for example, about 400% which is equal to or below the limit elongation rate.

In the present embodiment, between opposing faces of the elastomer sheets 1a and 1b, conductor wires 2a and 2b made of silver-coated fibers formed by coating surfaces of nylon fibers with silver are slightly twisted with each other, and disposed in the longitudinal directions of the elastomer sheets 1a and 1b, in a state of applying such a minimum tension as to fall within their center portions in the width directions.

In this extended state (initial extended state), the upper-side elastomer sheet 1a is placed on a support base, and when the upper surface of the lower-side elastomer sheet 1b is press-bonded thereto by using a press machine or the like, both end portions of the conductor wires 2a and 2b are fixed by the adhesive layers. Thus, as shown in a cross-sectional view on a right side of FIG. 1, formed are a sealed part 3a sealed by directly press-bonding both of the adhesive layers along the longitudinal direction without interposing the conductor wires 2a and 2b, and a conductor-wire stretchable part 3b in which outer peripheral ends of the conductor wires 2a and 2b are partially made in contact with the adhesive layers of the elastomer sheets 1a and 1b.

Incidentally, in this example, the sealed parts 3a are also formed on both sides of each end portion of the conductor wires 2a and 2b, and are continuously formed over the respective entire regions in a longitudinal direction as well as in a width direction of the conductor-wire stretchable part 3b.

In this manner, at the ends in the longitudinal directions as well as in the width directions of the elastomer sheets 1a and 1b in the sealed part 3a, both of the adhesive layers are directly press-bonded to each other so that the layers are firmly integrated. However, in the conductor-wire stretchable part 3b at their center portions, the adhesive layers such as urethane-based adhesives keeping high flexibility even after their curing are selected so that the conductor wires 2a and 2b can extend and contract in spiral shapes while their outer peripheral ends are made in contact with the adhesive layers.

Moreover, in the present embodiment, in order to reduce the resistance value, the two conductor wires 2a and 2b are used, and each of the wires selects a count of thread corresponding to about 0.3 mm in thickness by twisting a silver-coated fiber of 17 to 20µm per fiber.

However, in accordance with the resistance characteristic, the elongation rate, the number of repetitions of extension/contraction, or the like required for the stretchable wiring, wires having various counts of threads may be used, and such various combinations that the number of wires to be used is only one, or three or more may be selected.

Incidentally, when tape-shaped electrical connection portions electrically made in contact with the conductor wires 2a and 2b are stuck along the width directions onto the longitudinal both sides of the elastomer sheets 1a and 1b, the sealed parts 3a are not formed on the both sides of each end portion of the conductor wires 2a and 2b, the conductor wires 2a and 2b may be extended to the two ends in the longitudinal both ends of each of the conductor wires 2a and 2b.

Next, the holding devices, which hold the both ends of each of the elastomer sheets 1a and 1b in this state in the width directions, are made to come closer to each other, and the elastomer sheets 1a and 1b are returned to the natural lengths.

Along with the contractions of the elastomer sheets 1a and 1b, sliding occurs at each of contact portions between the adhesive layers and the outer peripheral ends of the conductor wires 2a and 2b inside the conductor-wire stretchable part 3b, and the conductor wires 2a and 2b are wound around in the spiral shapes to increase the number of twisting turns while being bent outward.

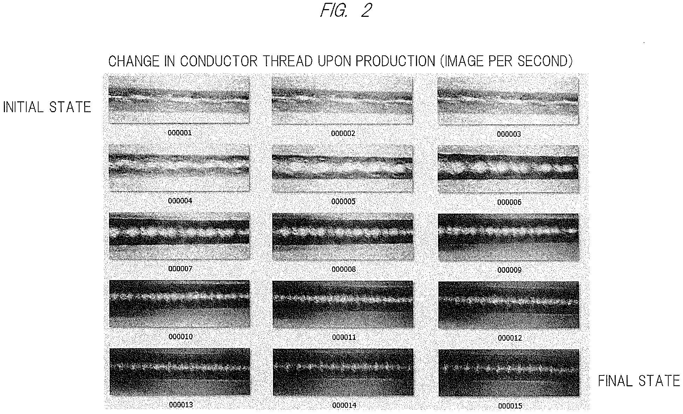

Those processes are actually photographed and shown by FIG. 2. An initial state of completing the adhesion onto the elastomer sheets 1a and 1b is set to 00001, a state of each process is photographed every second, and 00015 shows a state after a lapse of 15 seconds in which the elastomer sheets 1a and 1b are returned to their natural lengths by releasing their tension.

As understood by these results, it is found that as the holding devices are made closer to each other, the conductor wires 2a and 2b between the elastomer sheets 1a and 1b are wound around in the spiral shapes to increase the number of twists thereof, and an outer diameter of each of the conductor wires 2a and 2b is increased gradually, so that the number of twists thereof is further rapidly increased thereafter.

Incidentally, in FIG. 2, in order to confirm a state in which the conductor wires 2a and 2b are wound around in the spiral shapes and the number of twists thereof increases, their extended states are gradually returned to the natural lengths from an elongation rate of 400% by taking time of 15 seconds. However, experiments also show that the same phenomenon takes place even when the tension is released momentarily.

In order to examine a resistance change characteristic when the initial elongation rate is changed, a commercial urethane-based elastomer sheet (width: 1 cm, thickness: 10 µm) has been used as an elastomer sheet A, an urethane-gel-based adhesive has been used as an adhesive layer, five samples of elastomer sheets having natural lengths (2.4 mm, 2.3 mm, 2.3 mm, 2.3 mm, and 3.2 mm) described in a column of lengths have been respectively set to states of initial elongation rates of 0% (natural length), 100%, 200%, 300% and 400%. Under such situations, conductor wires have been sandwiched between the both elastomer sheets, and have adhered therebetween by the same procedure as that as described above, and thereby five kinds of samples are prepared.

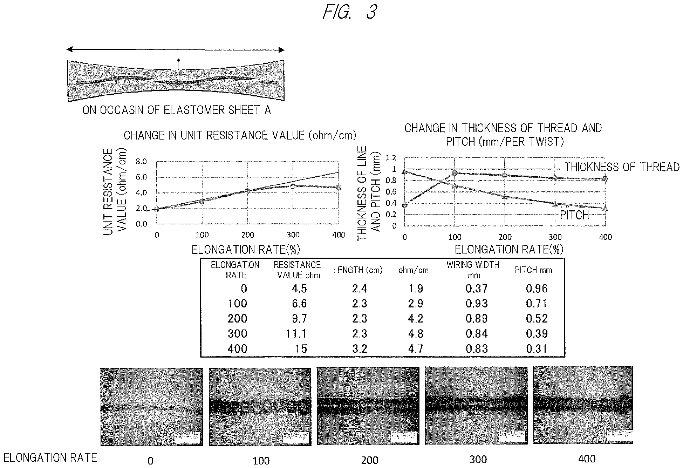

FIG. 3 shows measurement results of the entire resistance value ohm, a resistance value per 1 cm (unit resistance value: ohm/cm), a wiring width (width of conductor wire: mm), and a pitch of twists (length per one twist: mm) about each of these samples. Incidentally, used as the conductor wires haven been two conductor wires obtained by twisting silver-coated fibers each having 17 to 20µm per fiber to form a count of thread corresponding to 0.3 mm in thickness in the same manner as described above. Incidentally, the lowest side of FIG. 3 shows respective states of the conductor wires in returning the samples to their natural lengths.

As understood from the results, the pitch increases as the initial elongation rate increases (increase in the number of turns). However, when the initial elongation rate is 100% or more, a change in the wiring width is small, and until the initial elongation rate has reached 400%, the resistance value per 1 cm remains at 4.7 ohm/cm, so that a superior resistance change characteristic is exerted as the highly stretchable wiring.

As described above, the conductor wires are sandwiched and adhere between the opposing faces of the two extended elastomer sheets; when the elastomer sheets are returned to the natural lengths, the conductor wires are wound around in the a spiral shapes; and in order to achieve extension/contraction by the increase/reduction in the number of twists in response to the extension of the elastomer sheets, physical characteristics of the conductor wire such as pliableness and bendability (hereinafter, referred to as "windability") and physical characteristics of the adhesive layers such as flexibility and flowability after its curing need to be optimally combined with one another.

From these points of view, in addition to the above-mentioned embodiment in which the conductor wires made of the silver-coated fibers and the urethane-based adhesives are combined with each other, various structures about both of the conductor wires and stuck layers can be selected.

For example, when a conductor string using an extremely thin fiber made of stainless steel (10 µm to 20 µm) is used as the conductor wire, a conductor thread is hard in comparison with a nylon-based thread, and so it is necessary to strengthen a sealing force and develop a strong windability by making the elastomer sheet thicker or by increasing an adhesion of the adhesive.

In this case, for example, a silicon rubber sheet having about 0.5 mm in thickness can be used as a flexible sheet, and a silicon-based adhesive or the like having a strong adhesion strength can be used as the stuck layer.

Moreover, a rubber-based adhesive, an acryl-based adhesive, a silicon-based adhesive, an urethane-based adhesive may be used as the adhesive, and natural rubber, diene-based rubber, non-diene-based rubber, urethane-based elastomer, styrene-based elastomer, silicon-based elastomer or the like may be used as the elastomer sheet, so that any materials can be used as long as they have predetermined flexibility and high moldability.

Conductor members of any kinds such as metal plated fibers, metal fibers, enamel-coated extremely thin metal lines, carbon fibers, conductive high molecular-based fibers, and the like may be used also as the conductor wire, so that any materials can be used as long as they are highly conductive and pliable and have windability.

By combining various kinds of the physical characteristics of the elastomer sheets, the adhesives, and the conductor wires, predetermined stretchability and durability can be realized.

Incidentally, after the highly stretchable wiring of the present embodiment is produced by using the elastomer sheets having high durability, even if extension/contraction processes from the natural length to the extension at an elongation rate of 400% are repeated by about 200,000 times, no breaking has been caused in the elastomer sheets and the conductor wires 2a and 2b.

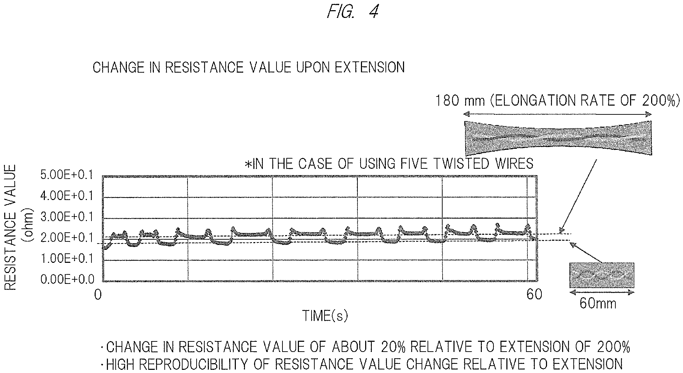

FIG. 4 shows the resistance-value change characteristic when the number of conductor wires is increased from two to five and the wires are extended up to 200%. Incidentally, when the number of conductor wires is increased, the resistance value can be reduced. However, since rigidity at the extension becomes higher, the maximum elongation rate is lowered.

As can be seen from these drawings, when the five twisted wires are used, the increase in the resistance value is about 20% relative to the elongation rate of 200%, so that it can be confirmed that reproducibility relative to the extension becomes high.

Next, described will be a termination connection of the highly stretchable wiring according to the present invention.

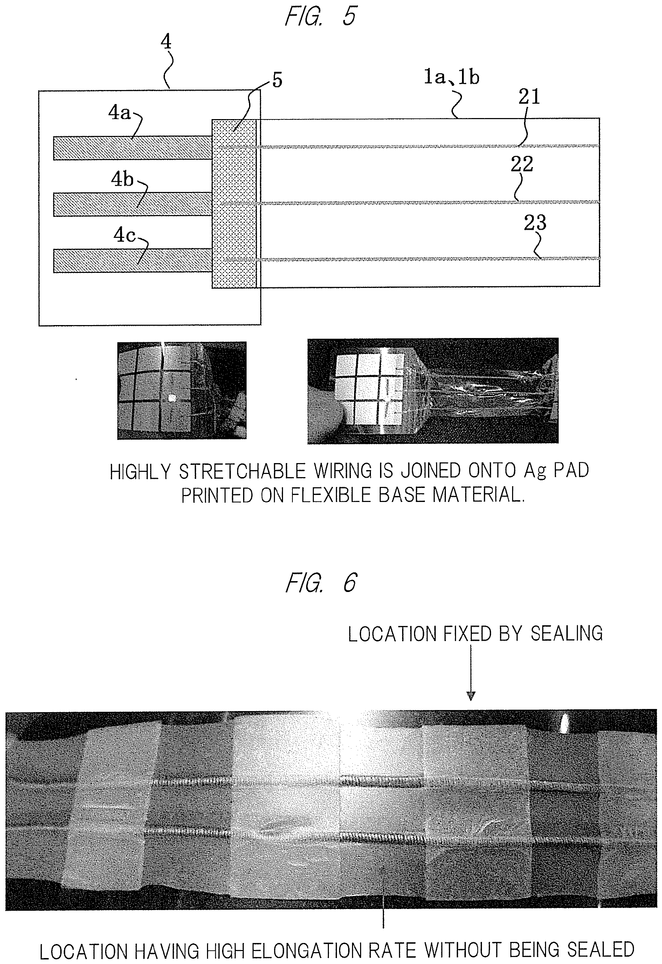

FIG. 5 shows a termination connection structure for electrically connecting a circuit base material and a termination of a highly stretchable wiring.

FIG. 5 shows an example in which three sets (21 to 23) of stretchable conductor wires are disposed in parallel between the elastomer sheets 1a and 1b in the same manner as in the aforementioned example, and their terminations in the length directions are respectively electrically connected with three terminals 4a to 4c of a circuit base material 4 such as a flexible substrate and a rigid substrate forming conductive patterns by printing.

In the vicinity of the respective end portions of the stretchable conductor wires 21 to 23 in the elastomer sheets 1a and 1b, the respective conductor wires are exposed by using ultrasonic waves and a spot laser and, for example, an anistropic conductive paste 5 is applied thereto in its width direction, so that these conductor wires are electrically connected to respective terminals 4a to 4c of the circuit base material 4 by press-bonding with heating. Thus, even if the highly stretchable wiring extends/contracts, the electrical conduction can be maintained for a long period of time without the conductor wire being exposed from the electrically connected portion.

Moreover, when one portion of the highly stretchable wiring of the present invention is stuck onto a fixed object, no extension/contraction occurs at the stuck portions, and the extension/contraction occurs between the stuck portions.

As shown in FIG. 6, when locations fixed by the stuck portions and non-fixed locations therebetween are alternately mixed with the same width, the non-fixed locations need to be extended/contracted by 200% with respect to the elongation rate of 100% required for the entire wiring. In this manner, although the very high elongation rate is partially required, no problem arises in the flexible conductor wire of the present invention since the resistance increase rate is low even under the elongation rate of about 400%.

Moreover, a high stress is generated in a border between a high stretchable location and a low stretchable location. However, if metal plated fibers are used as the conductor wires, durability against bending becomes higher in comparison with metal, so that the durability can be enhanced.

Next, described will be a matrix-shaped device in which the highly stretchable wirings of the present invention are disposed in a lattice shape and various electronic elements are disposed thereon.

In this case, a plurality of conductor wires each capable of extending and contracting in a spiral shape are arranged in parallel between two planar elastomer sheets and, in the same manner as in the previous example, are stuck between the opposing faces of the extended elastomer sheets so that two sheets of flat-plate shaped highly stretchable wirings provided with the conductor wires on a plurality of rows are formed.

Two sets of these are formed and stacked so that the rows of the conductor wires are orthogonal to each other, and the opposing faces thereof are integrally formed with an adhesive having the same component as that of each elastomer sheet or by thermal press-bonding.

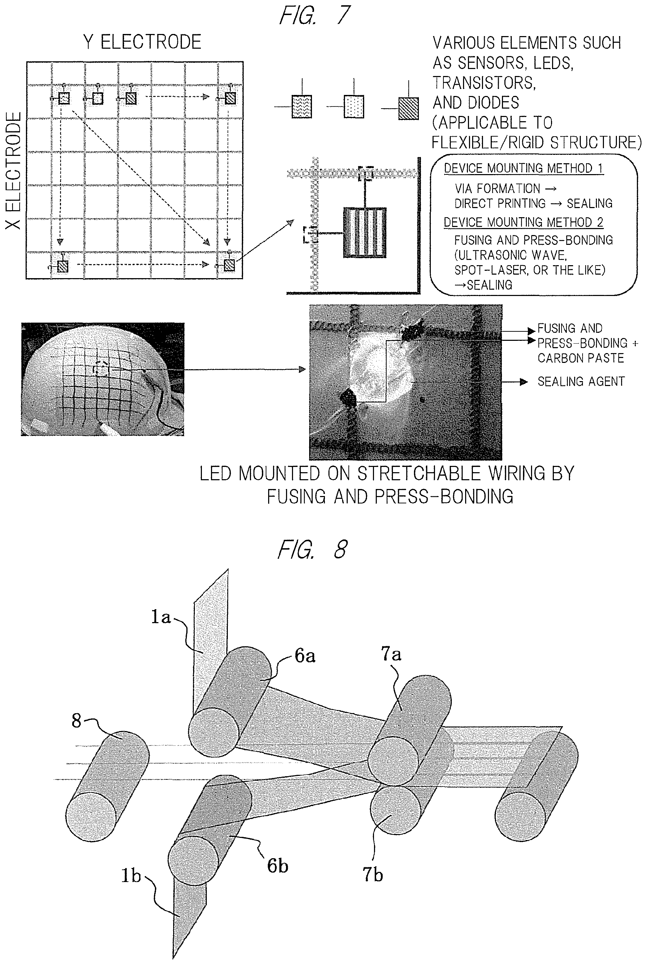

Moreover, as shown in FIG. 7, in the vicinity of those intersections, the conductor wires between the elastomer sheets are electrically connected with electrodes of an electronic element by conductor wires directly printed after formation of their vias.

At this time, by removing the interposed elastomer sheets using ultrasonic waves or a spot laser, the conductor wires between the elastomer sheets may be electrically connected with the electrodes of the electronic element by fusion and press-bonding or carbon-paste conductor wires so that the entire elastomer sheets inclusive of the electrically connected portions may be fixed by a sealing agent.

The matrix-shaped device of the present invention is highly flexible and easily adhere onto a human body.

Therefore, as electronic elements, for example, combining an LED, a stretchable sensor, a photodiode, a perspiration sensor, a muscle potential sensor, and a brain wave sensor, enables simultaneous mapping processes on muscle contraction and changes in blood flow, on biological sounds and changes in blood flow, on muscle contraction and perspiration, as well as on brain wave at a time of muscle contraction.

In particular, the matrix-shaped device of the present invention is superior in stretchability and also has high durability, and so is useful to walking instructions for maintaining health by disposing it on bottoms of shoes and measuring their pressure distribution.

Moreover, if the conductor wire itself is formed as a heater-use conductor wire having a high resistance value and carrying out a temperature control, it adheres to various locations of a human body so as to match the locations by utilizing its flexibility, and makes it possible to carry out a thermal therapy or the like.

Next, described will be a producing device for the highly stretchable wiring of the present invention.

In the above-mentioned embodiment, the highly stretchable wiring has been produced by using the following processes.
(1) With the stuck layers of the elastomer sheets 1a and 1b being opposed to each other, the upper surfaces in the width directions of the longitudinal both ends are held by the holding device, and the layers are extended up to the initial elongation rate that is equal to or below a limit elongation rate.
(2) The conductor wires are disposed between the opposing faces of the elastomer sheets 1a and 1b along the longitudinal direction in the state of applying minimum tension to such an extent as to fall within a range of the center portion in the width direction.
(3) The both elastomer sheets 1a and 1b are press-bonded to each other.
(4) In this state, the elastomer sheets 1a and 1b are returned to their natural lengths.

As shown in FIG. 8, when mass-production is carried out, rollers are used for transporting the both elastomer sheets and the conductor wires.

The upper-side elastomer sheet 1a and the lower-side elastomer sheet 1b are respectively sent through an upper elastomer-sheet supply roller 6a and a lower elastomer-sheet supply roller 6b from not-shown web rolls to pressurizing and press-bonding rollers 7a and 7b for mutually applying pressures from upper and lower sides.

In this example, from a conductor-wire supply roller 8, three conductor wires, which have turnability and are capable of extending and contracting in spiral shapes in a conductor-wire stretchable portion between the elastomer sheets, are sent out toward the pressurizing and press-bonding rollers 7a and 7b in a region between the opposing faces of the upper and lower elastomer sheets 1a and 1b, and adhere between the both elastomer sheets 1a and 1b.

Here, when a ratio between the number of driving rotations of the upper and lower elastomer-sheet supply rollers 6a and 6b and the number of driving rotations of the pressurizing and press-bonding rollers 7a and 7b is adjusted, the elongation rates to be given to the upper and lower elastomer sheets 1a and 1b between the both rollers can be adjusted.

On the other hand, if the number of rotations of the conductor-wire supply roller 8 is made substantially coincident with the number of driving rotations of the pressurizing and press-bonding rollers 7a and 7b, the conductor wires adhere between the upper-side elastomer sheet 1a and the lower-side elastomer sheet 1b in a state where excessive tension is not applied onto the conductor wires and their slacks are substantially removed.

Thereafter, the elastomer sheets are cut in the length direction by a slitter, and simultaneously each end portion is cut at a desired length, so that the highly stretchable wirings can be continuously produced.

Incidentally, when the matrix-shaped device previously explained is produced, the cutting in the length direction by the slitter may not be carried out.

### INDUSTRIAL APPLICABILITY

As explained above, since the highly stretchable wiring of the present invention makes it possible to reduce the change in resistance value due to the extension while exerting superior durability and stretchability at low costs, the utilization thereof can be expected in such wide fields as an antenna and/or wiring for an RFID apparatuses requiring flexibility, a wiring for a motion analyzing sensor in sports science, a garment-type heartbeat-electrocardiogram monitor, a wiring for a robot movable part, a wiring for use in a finger sensor for sending an instruction to a computer, a wiring for a bendable sensor attached to a finger, an elbow joint or a knee joint for remotely controlling a robot, a wiring for thermotherapy, or the like.

### EXPLANATION OF REFERENCE NUMERALS

1a, 1b ... elastomer sheet;
2a, 2b ... conductor wire;
3a ... sealing part;
3b ... conductor-wire stretchable part;
4 ... circuit base material;
5 ... anistropic conductive paste;
6a ... upper elastomer-sheet supply roller;
6b ... lower elastomer-sheet supply roller;
7a, 7b ... pressurizing and press-bonding roller; and
8 ... conductor-wire supply roller.

## Claims

1. A highly stretchable wiring capable of extension and contraction, the at least highly stretchable wiring comprising: two elastomer sheets each having an adhesive layer, the both adhesive layers adhering to each other along a longitudinal direction on wide-directional both sides; and a high windable conductor wire wound in a spiral shape and contracted when the elastomer sheets have natural lengths without being subjected to any tension, and extending by reducing the number of spiral turns according to extension due to tension applied between both ends of the elastomer sheets, wherein the conductor wire is interposed between the elastomer sheets, is extended from surfaces of the elastomer sheets on the both ends of the elastomer sheets, is electrically connected with a circuit element, and is fixed thereon.

2. The highly stretchable wiring according to claim 1, **characterized in that** a conductor wire formed by coating a surface of a stretchable fiber with silver is used as the conductor wire.

3. A matrix-shaped device **characterized in that**:
two sets of the highly stretchable wirings according to claim 1 or 2, in which a plurality of the conductor wires are arranged in parallel, adhere to each other so that arrangements of the both conductor wires are made orthogonal to each other; and
an electrode of the circuit element is connected to each of the both conductor wires.

4. A producing device for producing the highly stretchable wiring according to claim 1 or 2, **characterized by** comprising:
two elastomer-sheet supply rollers that feed the two elastomer sheets so as to oppose stuck layers formed on inner surfaces thereof;
a conductor-wire supply roller that is disposed between the two supply rollers and supplies a highly windable conductor wire between opposing faces of the flexible sheets; and
press-bonding rollers for press-bonding the both flexible sheets from outer surfaces thereof with the conductor wires being sandwiched between the opposing faces of the flexible sheets,
wherein a control device is provided between the elastomer-sheet supply rollers and the press-bonding rollers, the control device controlling rotation speed of the elastomer-sheet supply rollers so that the elastomer sheets are extended at a predetermined elongation rate, and also controlling the conductor-wire supply roller and the press-bonding rollers at the same rotation speed.

5. A producing method for a highly stretchable wiring, the producing method comprising the steps of:
extending two elastomer sheets, whose adhesive layers are opposed to each other, within a limit elongation rate or less by holding both ends thereof and applying tension thereto;
sandwiching a highly windable conductor wire between the both elastomer sheets, and adhering to each other with the conductor wire being fixed to the both ends of the elastomer sheets; and
releasing extension of the elastomer sheets to return to their natural lengths, winding around the conductor wire in a spiral shape, and contracting to the natural lengths.
